(19) Europäisches Patentamt
European Patent Office
Office européen des brevets

(11) **EP 3 839 547 A1**

(12) **EUROPEAN PATENT APPLICATION**

(43) Date of publication:
**23.06.2021 Bulletin 2021/25**

(51) Int Cl.:
*G01R 33/561* (2006.01)
*G01R 33/56* (2006.01)
*G01R 33/565* (2006.01)
*G01R 33/483* (2006.01)
*G06N 3/08* (2006.01)

(21) Application number: **19216400.2**

(22) Date of filing: **16.12.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicant: **Koninklijke Philips N.V.**
**5656 AG Eindhoven (NL)**

(72) Inventors:
• **NEHRKE, Kay**
  **5656 AE Eindhoven (NL)**
• **BOERNERT, Peter**
  **5656 AE Eindhoven (NL)**
• **WUELBERN, Jan Hendrik**
  **5656 AE Eindhoven (NL)**

(74) Representative: **Philips Intellectual Property & Standards**
**High Tech Campus 5**
**5656 AE Eindhoven (NL)**

(54) **SENSE MAGNETIC RESONANCE IMAGING RECONSTRUCTION USING NEURAL NETWORKS**

(57)     Disclosed herein is a method of training a neural network (214) to perform a SENSE magnetic resonance imaging reconstruction. The method comprises receiving (100) initial training data, wherein the initial training data comprises sets of initial training complex channel images each paired with a predetermined number of initial ground truth images. The method further comprises generating (102) additional training data by performing data augmentation on the initial training data such that the data augmentation comprises adding a distinct phase offset to each of the set of initial training complex channel images during generation of the sets of additional training complex channel images. The method further comprises inputting (104) the sets of additional training complex channel images into the neural network and receiving in response a predetermined number of output training images and performing deep learning using the output training images.

Fig. 1

**Description**

FIELD OF THE INVENTION

The invention relates to Magnetic Resonance Imaging, in particular to SENSE magnetic resonance imaging.

BACKGROUND OF THE INVENTION

A SENSE magnetic resonance imaging is a means of accelerating magnetic resonance imaging that exploits the fact that the individual antenna elements for receiver arrays which have separate acquisition channels have a spatially encoding effect. The same line of k-space acquired by different antenna elements contains different information. A coil sensitivity map which describe the spatial sensitivity of the antenna elements may be used to reconstruct a magnetic resonance image that samples less k-space than required by the Nyquist theorem. SENSE magnetic resonance imaging may be conducted for individual slices or entire volumes.

SENSE magnetic resonance imaging may also be performed by acquiring k-space data for several slices at once. The gradient magnetic fields may be used to divide the subject in to slices which respond to a particular resonance frequency. Multi-Band SENSE (MB-SENSE) uses Radio Frequency (RF) pulses that excite several slices at once. When reconstructed the measured complex channel images for each antenna element (or channel) excited by the MB pulse is superimposed in the image. To allow deconvolution or slice disentangling, the sampling pattern for MB-SENSE is chosen such that the images in the different excited slices are offset by a known CAIPIRINHA shift.

Bilgic et. al., "Highly accelerated multishot echo planar imaging through synergistic machine learning and joint reconstruction," Magnetic Resonance in Medicine, 2019; 82 1343-1358, discloses a method of performing a SENSE reconstruction that performs a hybrid machine learning and physics-based reconstruction. A U-Net type neural network is used to remove artifacts from an interim image.

SUMMARY OF THE INVENTION

The invention provides for a method, a medical system, and a computer program product in the independent claims. Embodiments are given in the dependent claims.

Embodiments may provide for an improved method of reconstructing a SENSE magnetic resonance image that does not require a coil sensitivity map. A neural network can be trained to reconstruct a SENSE image by performing data augmentation on the training data such that the training complex channel images resulting from the data augmentation have a phase offset added to them that for example can be chosen from a random distribution, a pseudorandom distribution, or predetermined distribution.

The images used to perform a SENSE reconstruction are complex, each voxel has a real and imaginary component. A complex image may be represented as two images, one with the real component and the other with the imaginary component. Alternatively, the magnitude and the phase may be used to represent the complex number for each voxel. Regardless of the representation, each voxel has a magnitude and a phase. In a magnetic resonance imaging system, the images from different coils or channels can have a phase offset due to various factors such as the radiofrequency system or antenna or the due to various properties of the detection channels those antennas are attached to. During a conventional SENSE reconstruction this difference in the phase offset is compensated for by the coil sensitivity map.

By performing data augmentation and adding a random phase offset to the resulting training complex channel images the neural network can be trained to automatically compensate for offsets in the phase.

In one aspect the invention provides for a method of training a neural network to perform a SENSE magnetic resonance imaging reconstruction. The neural network is configured to output a predetermined number of reconstructed images in response to inputting multiple measured complex channel images acquired according to a SENSE magnetic resonance imaging protocol. The multiple measured complex channel images are the images that are acquired by separate coil elements or antennas on separate radio frequency channels of a magnetic resonance imaging system.

The method comprises receiving initial training data. The initial training dataset comprises initial training complex channel images each paired with a predetermined number of initial ground truth images. The predetermined number of initial ground truth images has the same number as the predetermined number of reconstructed images. The initial training data may be obtained in several different ways. In one example the k-space data for a single test case may be acquired with complete sampling of the entire k-space so that the image from each channel can be reconstructed. This may then be used to reconstruct the initial ground truth image. The acquisition of the imaging according to a SENSE magnetic resonance imaging protocol can then be simulated. A portion of the k-space data used for one of the initial complex channel images can have part of its k-space data not used for the reconstruction. This may then result in aliasing or ghosting artifacts which simulate a real SENSE acquisition. In other instances, a magnetic resonance imaging protocol may acquire magnetic resonance imaging data or k-space data according to a SENSE magnetic resonance imaging protocol but then a coil sensitivity map is used to reconstruct the ground truth images.

The method further comprises generating additional training data by performing data augmentation on the initial training data. The initial training data comprises sets of additional training complex channel images each paired with a predetermined number of additional ground truth images. The predetermined number of reconstructed images has the same number as the predetermined number of additional ground truth images. The data augmentation comprises adding a distinct phase offset to each of the set of initial training complex channel images during generation of the set of additional training complex channel images. In this feature additional training data is generated using data augmentation. The traditional techniques of flipping the images, changing their scale and moving them may be used, however, an additional step is performed during the data augmentation.

Data for training the neural network may also be generated from fully SENSE reconstructed images and assuming different complex coil sensitivities to generate individual coil images which can be further subsampled via a Fast Fourier Transform (FFT).

The images which are input into the neural network, the multiple measured complex channel images are complex. The configuration of the RF system and other factors may lead to a random phase on different channels. This can also change between maintenance of the system and in different configurations. Conventionally neural networks are not able to deal with this change in the phase of the complex images that are input into it. To overcome this, during the data augmentation the phase is purposely randomized or changed. This then enables the neural network, after it has been trained, to accommodate these various phase offsets.

The method further comprises inputting the set of additional complex channel images into the neural network and receiving in response a predetermined number of output training images. The predetermined number of reconstructed images has the same number as the predetermined number of output training images. The method further comprises calculating the training vector by inputting the predetermined number of output training images and the predetermined number of ground truth images into a loss function. The method further comprises training the neural network by controlling the back-propagation algorithm with the training vector. These last three steps are the traditional means of training a neural network using deep learning.

In another embodiment the multiple measured complex channel images all have a predetermined input size. This is a specification of the dimensions of the voxels making up the images. The reconstructed images that are output by the neural network also have this same size.

In another embodiment the multiple measured complex channel images are reconstructed from k-space data that is acquired on separate radio frequency channels according to a SENSE magnetic resonance imaging protocol.

In another embodiment the neural network is a convolutional neural network.

In another embodiment the convolutional neural network is a so-called U-net. The use of a U-net may be beneficial because it is able to correlate spatial patterns on different scales and it is therefore useful in processing medical images.

In another embodiment the distinct phase offset is chosen from any one of the following: a random phase, a pseudo random phase, and from a chosen list of phases.

In another embodiment the predetermined number is 1. That is to say that only a single reconstructed SENSE image is output by the neural network. This may be considered to be a conventional SENSE magnetic resonance imaging protocol that processes data from a single slice.

In another embodiment the method further comprises removing a stitching artifact from the predetermined number of output training images before calculating the training vector. Due to the folding artifacts or multiple images in multi-band SENSE portions of the image may extend over the image boundary. If special measures are not taken with the input of the image and/or with the structure of the neural network this may result in stitching artifacts. This should be removed before calculating the training vector.

In another embodiment the neural network comprises convolutional layers. The convolutional layers are cyclical convolutional layers. This embodiment may be beneficial because the boundaries of the convolutional layers do not result in errors in processing the entire image. This may be very useful in eliminating so called stitching artifacts.

In another embodiment the method further comprises cyclically padding boundaries of the additional training complex channel images before inputting them into the neural network. Convolutional layers in particular do not process the outer edges of the voxels. A way of avoiding this difficulty is to take the images that are input into the neural network and then to add an additional boundary with the value of 0 in them.

In another embodiment the SENSE magnetic resonance imaging protocol is a multi-band SENSE magnetic resonance imaging protocol configured for acquiring a predetermined number of slices simultaneously. The predetermined number of reconstructed images has the same number as the number of predetermined number of slices. In magnetic resonance imaging a magnetic gradient may be used to select a particular slice to acquire k-space data for. In multi-band SENSE a radio frequency pulse is used which excites multiple slices simultaneously. An effect of this is that the resultant coil images or the multiple measured complex channel images then have an image from each of the slices that were acquired superimposed on each other.

Each of the predetermined number of output training images corresponds to one of the predetermined number of slices. When processing an image according to a multi-band SENSE these images which are superimposed on each other are then decomposed into the separate images. These are the predetermined number of output training images. Each of the predetermined number of output training images is offset by a layer-dependent translational shift, as applied in usual measurements to better condition the SENSE unfolding problem. A CAIPIRINHA shift is an example of a translational shift that may be used. References herein to the term CAIPIRINHA shift are intended to be representative of translational shifts for multi-band SENSE reconstructions in general.

The method further comprises shifting each of the predetermined number of ground truth images by the layer-dependent translational shift before calculating the training vector. To enable the disentangling of the images in multi-band SENSE the k-space is sampled such that the different layers have a different phase offset. This causes the images to shift within the image.

In another embodiment the layer-dependent translational shift is a layer-dependent CAIPIRINHA shift.

In another embodiment the method further comprises padding k-space data of the training complex channel images so that it is divisible by the predetermined number. This for example may be performed before the multiple measured complex channel images are acquired.

In another aspect the invention provides for a medical system that comprises a memory storing machine-executable instructions and a neural network. The neural network is configured for performed a SENSE magnetic resonance imaging reconstruction by outputting a predetermined number of reconstructed images in response to inputting multiple measured complex channel images acquired according to a SENSE magnetic resonance imaging protocol.

The medical system further comprises a processor that is configured for controlling the medical system. Execution of the machine-executable instructions causes the processor to receive the multiple measured complex channel images. Execution of the machine-executable instructions further causes the processor to receive the predetermined number of reconstructed images by inputting multiple measured complex channel images into the neural network. The predetermined number of reconstructed images are received from the neural network in response.

In another embodiment the neural network is trained according to an embodiment.

In another embodiment the neural network is trained such that the stitching artifact was removed from the predetermined number of output training images before calculating the training vector. Execution of the machine-executable instructions further cause the processor to remove a stitching artifact from each of the predetermined number of reconstructed images. This embodiment may be beneficial because the complex channel images may have information nearer the edge of boundary of the image. The neural network may have layers such as convolutional layers which are unable to process the information in the outer edges of the image. This may result in a stitching artifact.

When there are multiple reconstructed images the location of the stitching artifact may sometimes be located by the position of a layer-dependent translational shift.

In another embodiment the neural network is trained such that the training images had cyclically padding boundaries before they were input into the neural network during the training procedure. This may be beneficial particularly for neural networks that have convolutional layers. The use of the cyclical padding may eliminate the generation of stitching artifacts.

In another embodiment the SENSE magnetic resonance imaging protocol is a multi-band SENSE magnetic resonance imaging protocol configured for acquiring a predetermined number of slices simultaneously. Each of the predetermined number of reconstructed images corresponds to one of the predetermined number of slices. Each of the predetermined number of output training images is offset by a layer-dependent translational shift. Execution of the machine-executable instructions further causes the processor to shift each of the predetermined number of reconstructed images by the layer-dependent translational shift.

In another embodiment the predetermined number of reconstructed images is 1. This may be interpreted as a conventional SENSE magnetic resonance imaging protocol where the SENSE magnetic resonance imaging protocol is in a phase encoding direction. This could be a two-dimensional image or even a three-dimensional image. The SENSE problem into three-dimensional MRI imaging could be performed using a larger neural network.

In another embodiment the medical system further comprises a magnetic resonance imaging system. The magnetic resonance imaging system further comprises a multi-channel RF system configured for acquiring antenna element-dependent k-space data from an imaging zone of the magnetic resonance imaging system. The memory further stores pulse sequence commands configured for acquiring the antenna element-dependent k-space data according to the SENSE magnetic resonance imaging protocol. Execution of the machine-executable instructions causes the processor to acquire the antenna element-dependent k-space data by controlling the magnetic resonance imaging system with the pulse sequence commands. Execution of the machine-executable instructions further causes the processor to reconstruct the multiple measured complex channel images from the antenna element-dependent k-space data.

In another embodiment the pulse sequence commands are further configured to control the magnetic resonance imaging system to acquire a coil sensitivity map k-space data according to the SENSE magnetic resonance imaging protocol. Execution of the machine-executable instructions further causes the processor to acquire the coil sensitivity map k-space data by controlling the magnetic resonance imaging system with the pulse sequence commands. Execution of the machine-executable instructions further cause the processor to reconstruct a coil sensitivity map from the coil sensitivity map k-space data. Execution of the machine-executable instructions further cause the processor to reconstruct a predetermined number of algorithmically reconstructed images from the antenna element-dependent k-space data and the coil sensitivity map. In this step the SENSE reconstruction is performed using a conventional SENSE reconstruction protocol that uses the coil sensitivity map.

Execution of the machine-executable instructions further cause the processor to receive a quality indicator descriptive of the predetermined number of algorithmically reconstructed images. The quality indicator indicates a successful reconstruction or a failed reconstruction. The quality indicator could be provided in several different ways. For example, one or more of the predetermined number of algorithmically reconstructed images could be displayed on a display or user interface. The quality indicator could then be received from a graphical user interface. In other instances, the predetermined number of algorithmically reconstructed images could for example be input into a neural network train to recognize image artifacts or it could be put into a different system which is programmed to detect reconstruction artifacts. The receiving of the quality indicator may be performed automatically or may be data that was received from the user interface.

Execution of the machine-executable instructions further cause the processor to store the predetermined number of algorithmically reconstructed images as subject images in the memory if the quality indicator indicates a successful reconstruction. In this step the algorithmically reconstructed images are stored as the subject images. Execution of the machine-executable instructions further cause the processor to proceed with inputting multiple measured complex channel images into the neural network if the quality indicator indicates a failed reconstruction and then storing the predetermined number of reconstructed images as the subject images in the memory if the quality indicator indicates a failed reconstruction. In this embodiment a normal SENSE reconstruction using a coil sensitivity map is performed. If the reconstruction fails, for example the subject may have moved after the coil sensitivity map has been acquired then the reconstruction will fail. In this case the neural network may be used as a second chance to use the data which would otherwise be corrupted and unusable. This for example may reduce the amount of time spent on average to acquire SENSE images.

In another aspect the invention provides for a computer program product comprising a neural network and machine-executable instructions for execution by a processor controlling a medical system. The neural network is configured for performing a SENSE magnetic resonance imaging reconstruction by outputting at least one reconstructed image in response to inputting multiple measured complex channel images acquired according to a SENSE magnetic resonance imaging protocol. Execution of the machine-executable instructions causes the processor to receive the multiple measured complex channel images. Execution of the machine-executable instructions further causes the processor to receive the at least one reconstructed image by inputting multiple measured complex channel images into the neural network.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

k-space data is defined herein as being the recorded measurements of radio frequency signals emitted by atomic spins using the antenna of a Magnetic resonance apparatus during a magnetic resonance imaging scan. A Magnetic Resonance Imaging (MRI) image or MR image is defined herein as being the reconstructed two- or three-dimensional visualization of anatomic data contained within the k-space data. This visualization can be performed using a computer.

A complex image is an image that comprises a complex value for each pixel or voxel. One way inputting a complex image into a neural network is to divide the image into a real component and a complex component. The two components can then be input into a neural network as two separate images.

BRIEF DESCRIPTION OF THE DRAWINGS

In the following preferred embodiments of the invention will be described, by way of example only, and with reference to the drawings in which:

Fig. 1 shows a flow chart which illustrates a method of training a neural network;
Fig. 2 illustrates an example of a medical system;
Fig. 3 shows a flow chart which illustrates a method of operating the medical system of Fig. 2;
Fig. 4 illustrates a further example of a medical system;
Fig. 5 shows a flow chart which illustrates a method operating the medical system of Fig. 4;
Fig. 6 illustrates a method of training a neural network for performing a SENSE reconstruction;
Fig. 7 compares synthesized and measured multi-band sense coil images;
Fig. 8 illustrates stitching artifact removal; and
Fig. 9 compares images reconstructed using algorithmic and neural network based multi-band SENSE reconstructions to fully sampled images.

DETAILED DESCRIPTION OF THE EMBODIMENTS

Like numbered elements in these figures are either equivalent elements or perform the same function. Elements which have been discussed previously will not necessarily be discussed in later figures if the function is equivalent.

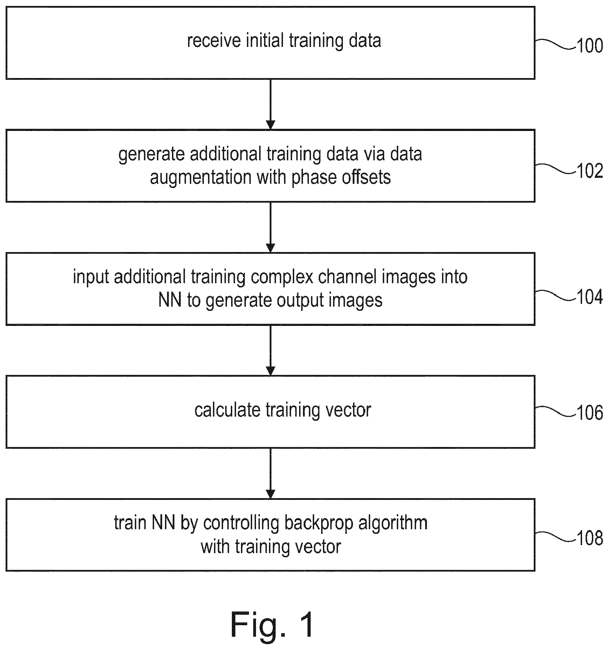

Fig. 1 shows a Fig. which illustrates a method of training a neural network to perform a SENSE magnetic resonance imaging reconstruction. First in step 100, initial training data is received. The initial training data comprises sets of initial training complex channel images each paired with a predetermined number of initial ground truth images. The initial training complex channel images are what are input into the neural network. The output of the neural network is then compared with the initial ground truth images to perform the deep learning of the neural network.

Next, in step 102, additional training data is generated by performing data augmentation on the initial training data. All of the traditional methods of data augmentation such as moving the location of images, rescaling them, inverting them and such may be performed. In this step however, the training complex channel images are additionally modified by adding a distinct phase offset to each of the set of initial training complex channel images. The images are represented in complex phase as both a real and imaginary component. This for example may be represented by two images of the same side; one has the real component and one has the imaginary component. It is also possible to represent each of these complex numbers as a magnitude and a phase. For each voxel the complex value of the voxel may be calculated in terms of phase and amplitude and then modified by adding a distinct phase offset to each channel.

After adding this phase offset then the new real and imaginary components for the two images which represent a single complex image may be calculated. This may be beneficial in the data augmentation because in real life magnetic resonance imaging systems there may be phase differences due to the wiring or the configuration of the coils and things like this. Adding the distinct phase offset then trains the neural network to function even when there are varying phase relationships.

The method then proceeds to step 104 where the sets of additional training complex channel images are input into the neural network and in response a predetermined number of output training images is received. Then in step 4 a training vector is calculated by comparing the predetermined number of output training images and the predetermined number of ground truth images into a loss function. Finally, in step 108, the neural network is trained by controlling a back-propagation algorithm with the training vector.

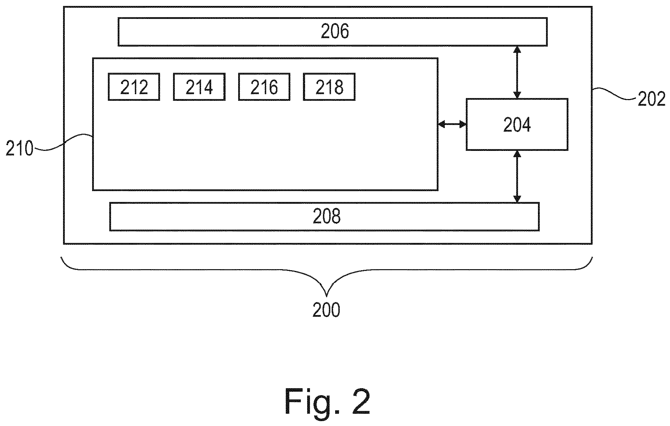

Fig. 2 illustrates an example of a medical system 200. The medical system 200 is shown as comprising a computer 202. The computer controls a processor 204 that is connected to a hardware interface 206, an optional user interface 208, and a memory 210. The hardware interface 206 may for example comprise such components or interfaces as a network interface. The hardware interface 206 may for example enable the processor 204 to communicate with other computer systems and/or to control other components of the medical system 200. The processor 204 is intended to represent one or more cores in one or more computing machines or devices. The user interface 208 may for example be used for the display of information and to provide a control for the medical system 200. The memory 210 may be any memory which is accessible to the processor.

The memory 210 is shown as containing machine-executable instructions 212. The machine-executable instructions 212 contain instructions which enable the processor 204 to control other components of the medical system 200 as well as to perform various data and image processing tasks. The memory 210 is further shown as containing a neural network. The neural network is configured for performing a SENSE magnetic resonance imaging reconstruction. This may be performed by inputting multiple measured complex channel images acquired according to a SENSE magnetic resonance imaging protocol. In response a predetermined number of reconstructed images is output. The memory 210 is shown as containing multiple measured complex channel images 216. The memory 210 is further shown as containing a predetermined number of reconstructed images 218 that were generated by inputting the multiple measured complex channel images 216 into the neural network 214.

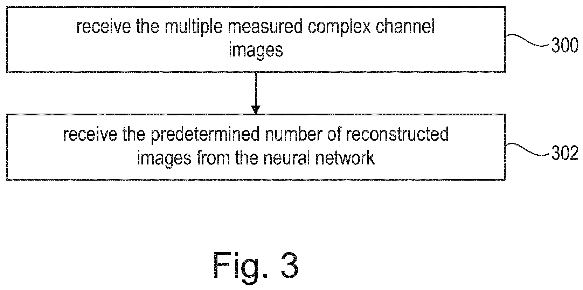

Fig. 3 shows a flowchart which illustrates a method of operating the medical system 200 of Fig. 2. First in step 300 the multiple measured complex channel images 216 are received. Next in step 302 the predetermined number of reconstructed images 218 are received or generated by inputting the multiple measured complex channel images 216 into the neural network 214.

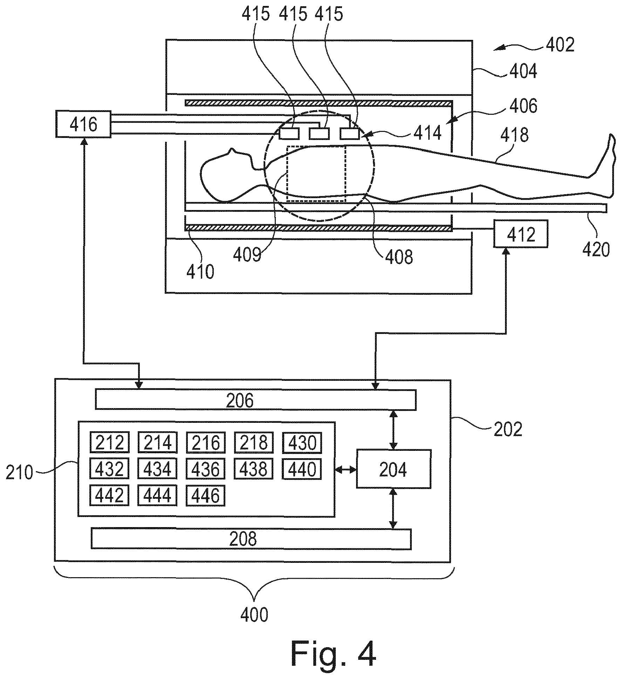

Fig. 4 shows a further view of a medical instrument 400. This medical instrument is similar to the one illustrated in Fig. 2 except it additionally comprises a magnetic resonance imaging system 402. The magnetic resonance imaging system 402 comprises a magnet 404. The magnet 404 is a superconducting cylindrical type magnet with a bore 406 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 406 of the cylindrical magnet 404 there is an imaging zone 408 where the magnetic field is strong and uniform enough to perform magnetic resonance imaging. A region of interest 409 is shown within the imaging zone 408. The magnetic resonance data that is acquired typically acquried for the region of interest. A subject 418 is shown as being supported by a subject support 420 such that at least a portion of the subject 418 is within the imaging zone 408 and the region of interest 409.

Within the bore 406 of the magnet there is also a set of magnetic field gradient coils 410 which is used for acquisition of preliminary magnetic resonance data to spatially encode magnetic spins within the imaging zone 408 of the magnet 404. The magnetic field gradient coils 410 connected to a magnetic field gradient coil power supply 412. The magnetic field gradient coils 410 are intended to be representative. Typically magnetic field gradient coils 410 contain three separate sets of coils for spatially encoding in three orthogonal spatial directions. A magnetic field gradient power supply supplies current to the magnetic field gradient coils. The current supplied to the magnetic field gradient coils 410 is controlled as a function of time and may be ramped or pulsed.

Adjacent to the imaging zone 408 is a radio-frequency coil 414 for manipulating the orientations of magnetic spins within the imaging zone 408 and for receiving radio transmissions from spins also within the imaging zone 408. The radio frequency coil 414 is shown as comprising multiple antenna elements 415. The multiple antenna elements 415 are used to each acquire k-space data during the SENSE magnetic resonance imaging protocol.

The radio-frequency coil 414 is connected to a radio frequency transceiver 416. The radio-frequency coil 414 and radio frequency transceiver 416 may be replaced by separate transmit and receive coils and a separate transmitter and receiver. It is understood that the radio-frequency coil 414 and the radio frequency transceiver 416 are representative. The radio-frequency coil 414 is intended to also represent a dedicated transmit antenna and a dedicated receive antenna. Likewise the transceiver 416 may also represent a separate transmitter and receivers. The radio-frequency coil 414 has multiple receive/transmit elements 415 and the radio frequency transceiver 416 may has multiple receive/transmit channels.

The transceiver 416 and the gradient controller 412 are shown as being connected to the hardware interface 106 of a computer system 102. The memory 210 is further shown as containing pulse sequence commands 430. The pulse sequence commands are configured for controlling the magnetic resonance imaging system to acquire k-space data according to a SENSE magnetic resonance imaging protocol. The pulse sequence commands 430 may also optionally be configured to acquire data for constructing a coil sensitivity map.

The memory 210 is further shown as containing antenna element dependent k-space data 432 that was acquired by controlling the magnetic resonance imaging system 402 with the pulse sequence commands 430. The memory 210 is also shown as optionally containing coil sensitivity map k-space data 434 that was also acquired by controlling the magnetic resonance imaging system 402 with the pulse sequence commands 430. The memory 210 is further shown as containing a coil sensitivity map 436 that was reconstructed from the coil sensitivity map k-space data 434.

The memory 210 is further shown as containing a SENSE reconstruction algorithm 438. To use this, the antenna element dependent k-space data 432 is first reconstructed into the multiple measured complex channel images 216. There is one channel that corresponds to each antenna element. Then the multiple measured complex channel images 216 and the coil sensitivity map 436 are used by the SENSE reconstruction algorithm 438 to construct a number of algorithmically reconstructed images 440 according to the SENSE magnetic resonance imaging protocol. The memory 210 is shown as optionally containing an image artifact detection module 442. For example, the algorithmically reconstructed images 440 can be input and folding artifacts and other artifacts for example might be detected using a neural network or other detection algorithm. Also, the algorithmically reconstructed images 440 could be displayed using a display of the user interface 208 to display them to a user. The user may then provide a quality indicator 444.

The image artifact detection module 442 may also be used to provide a quality indicator as an alternative. If the quality indicator 444 indicates that the algorithmically reconstructed images 440 have a sufficient quality they are then stored as a subject image 446. If not then the processor 204 may input the multiple measured complex channel images 216 into the neural network 214. The use of the optional SENSE coil sensitivity map 436 provides a system that may first try to correctly measure the coil sensitivity map and reconstruct the SENSE images and if this fails the neural network is then used as a second chance to try to reconstruct the SENSE images.

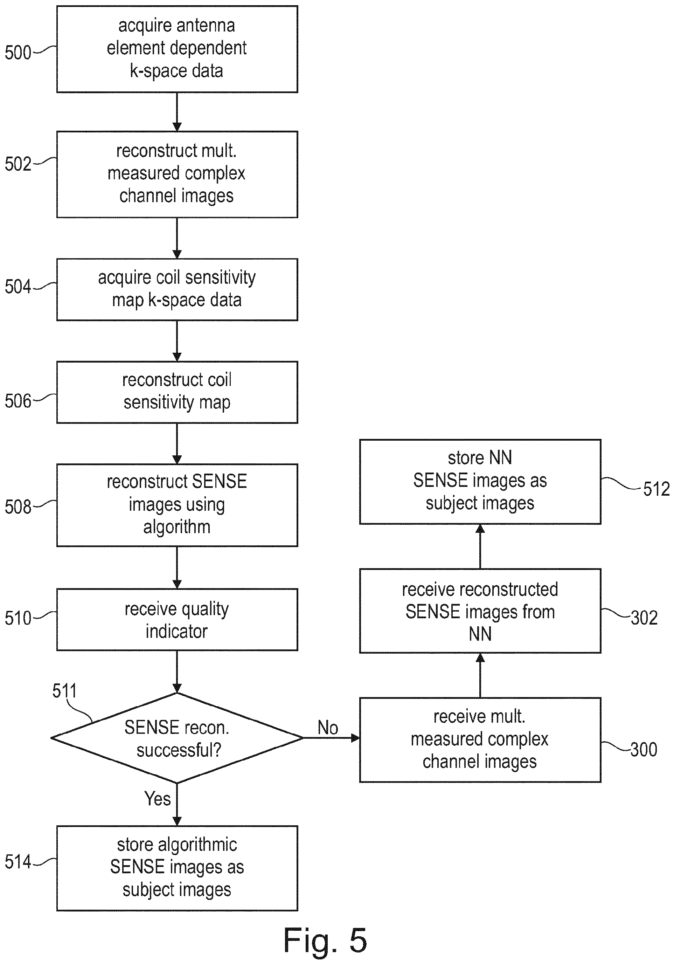

Fig. 5 illustrates a method of operating the medical system 400 of Fig. 4. First in step 500 the antenna element dependent k-space data 432 is acquired by controlling the magnetic resonance imaging system 402 with the pulse sequence commands 430. Next in step 502 the multiple measured complex channel images 216 are reconstructed from the antenna element-dependent k-space data 432. Then in step 504 the coil sensitivity map k-space data 434 is acquired by controlling the magnetic resonance imaging system with the pulse sequence commands 430. The coil sensitivity map k-space data 434 can be acquired before the antenna element k-space data 432. Then in step 506, the coil sensitivity map 436 is reconstructed from the coil sensitivity map k-space data 434 according to a SENSE magnetic resonance imaging protocol. The coil sensitivity map 436 may be reconstructed before the multiple measured complex channel images 216 are reconstructed.

Then in step 508 the predetermined number of algorithmically reconstructed images 440 are reconstructed using the coil sensitivity map 436 and the multiple measured complex channel images 216 as input to the SENSE reconstruction algorithm 438. Next in step 510 a quality indicator is received that is descriptive of the predetermined number of algorithmically reconstructed images 440. As was mentioned above, this may be done automatically or may be signals that are received via the user interface. Step 511 is a decision box and the question is: is the reconstruction successful. If the answer is yes then the method proceeds to step 514 and the predetermined number of algorithmically reconstructed images are stored in the memory 210 as subject images 446. If the answer is no then the method proceeds to steps 300 and 302 of Fig. 3. After step 302, step 512 is performed. In step 512 the predetermined number of reconstructed images 218 are stored in the memory as the subject image or images 446.

Parallel Imaging methods like SENSE employ receive coil arrays to trade SNR against scan time by under sampling. However, SENSE requires an additional coil sensitivity scan (reference scan) to unfold the under sampled images, which takes some extra scan time. Moreover, motion-corruption of the ref scan will potentially propagate into the SENSE reconstruction of the subsequent diagnostic scan impairing image quality.

Examples may provide for a neural network for reconstruction of the undersampled data without the need of a SENSE reference scan, thus improving the motion robustness and the workflow significantly.

SENSE is a parallel imaging technique, which allows the reconstruction of under sampled MRI data by employing the complementary spatial information provided by a receive coil array. Thus, an additional calibration scan, the so-called SENSE reference scan, is required to determine the spatial sensitivities of the individual receive coil elements of the employed array to unfold the backfolded under sampled images. Multiband (MB)-SENSE is a parallel imaging technique, which applies the sensitivity encoding idea not in the phase encoding direction, but in the slice, direction using SENSE to disentangle the simultaneously acquired slices.

The U-NET is a type of convolutional neural network (CNN) topology, which was proposed for biomedical image segmentation tasks. The network consists of a contracting path and an expansive path, which leads to the u-shaped architecture. The contracting path is a typical convolutional network that consists of repeated application of convolutions, each followed by a rectified linear unit (ReLU) and a max pooling operation. During the contraction, the spatial information is reduced while feature information is increased. The expansive pathway combines the feature and spatial information through a sequence of up-convolutions and concatenations with high-resolution features from the contracting path.

Neural networks have been shown to improve parallel image reconstruction, however focusing on non-uniform under sampling patterns with auto calibration lines or enhancing compressed sensing strategies. A multilayer perceptron architecture has been used to remove aliasing artefacts from uniformly under sampled images, however, for reduction factors up to 2 only.

As outlined above, standard SENSE requires a reference scan, which needs extra scan time for acquisition and may increase motion sensitivity. Moreover, the imperfect orthogonality of the coil sensitivities and thus coil data will result in noise enhancement in the reconstructed images, especially at higher SENSE factors.

MRI data is complex-valued data. This is due to the complex transmit and receive coil sensitivities showing a spatial phase variation. Moreover, effects like off-resonance, imperfect shims, eddy currents, etc., cause spatial phase variations in the reconstructed images. The spatial phase variations of the data originating from the individual receive coil elements provide essential information required for the unfolding of undersampled images by the SENSE algorithm, and it is clear that also a neural network used for image unfolding will benefit from this information. However, the global phase offsets of the individual receive coil elements are a matter of MRI system calibration and are arbitrary. Also, BO and B0-shim related phase variations are arbitrary and difficult to predict. Therefore, the neural networks have to utilize the spatial phase variation of the receive coils, without getting confused by phase variations originating from other sources, which is a difficult task.

Examples may provide for an appropriately configured multi-dimensional neural network (e.g. a U-net) to do SENSE reconstructions without any knowledge of coil sensitivities of coil correlation kernels.

Such an invention can find many applications in 2D multi-slice and potentially also in 3D (or even higher dimensional) MR imaging reconstructing images in case of no or incomplete or corrupted coil sensitivity information.

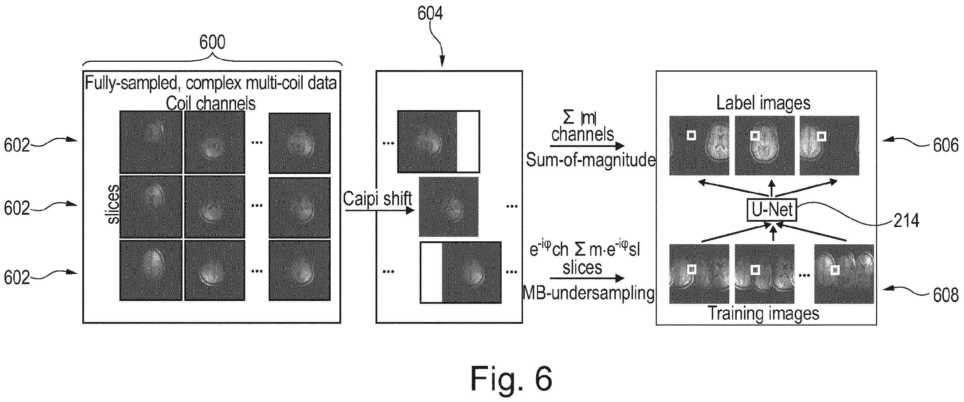

The application of a U-NET neural network to perform a SENSE reconstruction is discussed below. The Cartesian under sampled data in image space (i.e. the back-folded images) are used as input for a neural network. The N complex receive channels result in 2N real input channels (real and imaginary part can be handled as separate channels) for the U-net. The output images have the same size as the input images, where the number of output channels corresponds to the under-sampling factor R usually also dubbed in SENSE as acceleration factor. Thus, the aliasing structures in the backfolded source images are separated into different output channels (Fig. 6 below), those are appropriately shifted to reflect the conditions during the actual measurement. This structure makes use of the fact that the backfolding pattern, including the shifting CAIPIRINHA, is known in advance, and hence, the neural network needs solely performing unfolding of local features without considering long distances. For the output images, modulus images are considered (e.g. sum of squares or sum of magnitudes). For the network, a standard U-Net (see below) is proposed, that learns the relation between the input (N folded complex images) to the output (R unfolded output images).

Fig. 6 illustrates a way of generating training data for training the neural network 214. First fully sampled complex multi-coil data 600 is acquired. This is data for individual channels 602. Complete images are reconstructed and these are used to generate images with a simulated CAIPIRINHA shift or other translational shift. These images may be used to calculate additional ground truth images 606 or label images. This is done by calculating a sum of magnitudes. By combining images and performing under sampling training images 608 may be generated. These training images have the random phase component added to them and they are therefore the additional training complex channel images 608.

Fig. 6 illustrates a MB-SENSE reconstruction using a U-NET neural network. For training of the U-Net, label images and training images can be derived from fully sampled images. First, the fully-sampled images are shifted in phase-encoding direction according to the CAIPIRINHA shift selected for the under sampled acquisition to reduce the g factor (e.g. 1/3 field-of-view for MB-factor = 3). The fully sampled label images are generated by superposition of the images from the different receive channels using e.g. sum-of-magnitude or root-sum-of-squares. The under sampled training images are generated by superposition of the slices belonging to one MB acquisition. During training, random phases are applied to each receive channel ($\varphi_{ch}$) and to each slice ($\varphi_{s1}$) to improve robustness against potential phase variations. The yellow boxes in the label and training images on the right illustrate that the features remain at their positions in the image.

Fully sampled images are used for synthetization of training data (cf. Fig 1 for details). Both training and label images can be synthesized from the fully sampled images training images by appropriate superposition in image space.

Phase variations from B0 shims, eddy currents, etc. are a big problem for U-Net (and other neural networks) based reconstruction of under sampled images, because the actual phase affects the interference pattern (add or subtract) of the aliased images (Fig 2). This can effectively be addressed using data augmentation. During synthetization of the MB images used for training, random phase shifts $\varphi_{s1}$ are applied to each sub-slice. This can be done statically (in advance) or on-the-fly during training. As a side effect, this augmentation addresses also the Wong phase used for peak B1+ reduction during transmission, which does not have to be accounted for separately. It is conceivable to add instead of the constant also a linear phase variation across the images during training.

In addition, to address arbitrary phase offsets of the receive channels, random phase offsets $\varphi_{ch}$ are added to the receive channel. This makes the neural network robust against channel dependent phase changes after e.g. a recalibration or installation of the system. The mathematical formula is given in the following,

$$m_{synth.ch} = e^{-i\varphi_{ch}} \sum_{sl=0}^{mb-factor} m_{sl.ch} \cdot e^{-i\varphi_{sl}}$$

[1]

where $m_{sl,ch}$ where denotes the shifted source data image for MB slice $sl$ and receive channel $ch$, and $m_{synth,ch}$ is the resulting augmented synthesized training image for receive channel $ch$. Ideally, the phase augmentation is repeated for each training epoch to increase the variability of the data, and hence the robustness of learning.

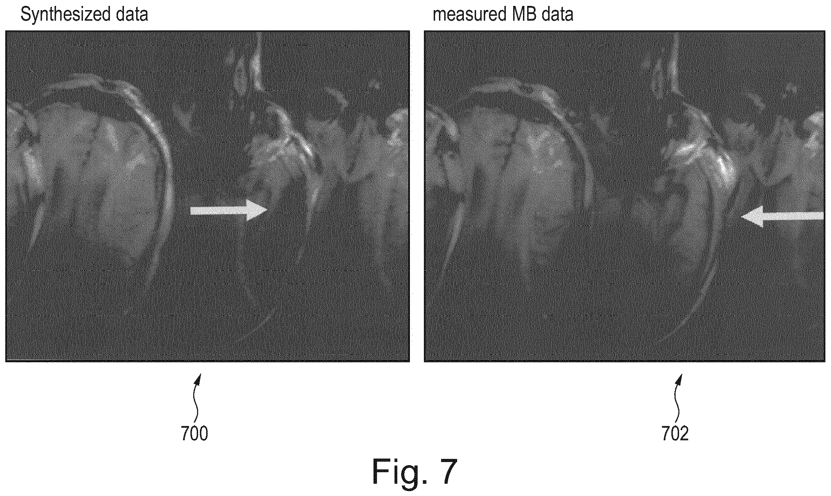

Fig. 7 illustrates synthesized data 700 and measured MB data 702. It can be seen that these result in different interference patterns where the arrow is located. This difference may be caused by phase variations caused by the B0 shim eddy currents or other factors. This illustrates the importance of performing the data augmentation with a phase variation.

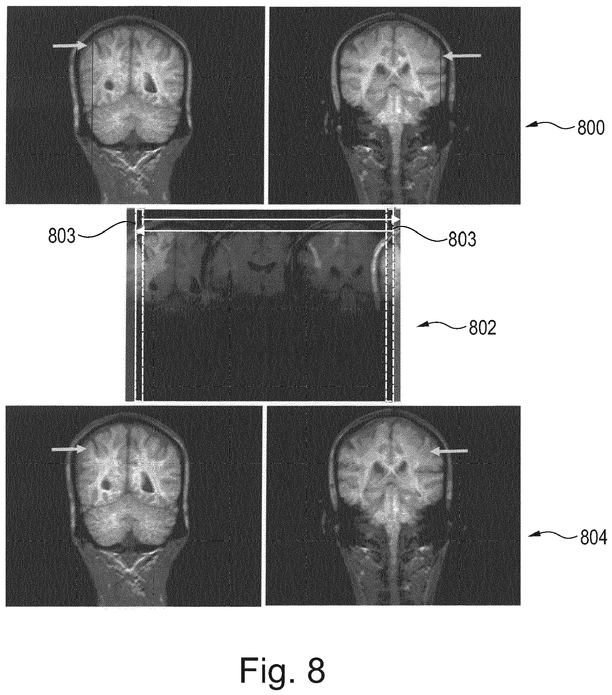

For the image data layout described above the output images of the U-Net may be shifted to correct for the CAIPIRINHA shift, which may result in stitching artifacts resulting from the imperfect convolution performed by the U-Net at the image borders (Fig. 8 below). These artifacts can be avoided by cyclic padding of the input data and training the network on the padded data. The reconstructed images are then cropped to the original size and shifted back. An alternative approach would be to implement a cyclic convolution for the U-Net.

Fig. 8 illustrates a stitching artifact removal. The images in the top row labeled 800 show two images with a stitching artifact indicated by the arrows. This for example may be caused by cyclic shifting of U-net reconstructed images. One way of avoiding this is to perform cyclical padding of the training data. The image in the middle 802 shows an additional padding region 803 that has been added to the image 802. This may be added to the training data. The images 804 show the results of a reconstruction by a neural network that used training data similar to the image in 802. In this example the arrows do not show the stitching artifact.

Example I:

Experiments were performed on ten healthy volunteers using a 3T MRI scanner. A standard brain survey scan (3 orientations: SAG, TRA, COR, 3 slices, about 30 s scan time) was acquired for nine different head postures (moving head both from left to right and from neck to chest). In addition, corresponding MB acquisitions were performed (3 orientations: SAG, TRA, COR, MB-factor=3, shift factor = 3, about 10 s scan time). The fully sampled standard survey images of nine volunteers were used to train a U-Net for MB reconstruction as described above (cf. Fig. 8) using the Keras API of Tensorflow. The U-Net consisted of 4 down-sampling steps (each preceded by two convolution steps) and corresponding up-sampling steps and convolutions. Stochastic gradient descent using least-squares was used as optimizer. On-the-fly data augmentation as described above was performed to account for phase variations.
The trained U-Net was used to reconstruct the MB images of the remaining volunteer, which was not used for training of the network. While MB-SENSE leads to severe artifacts when the head posture changes between ref scan and MB-scan, the MB-U-Net reconstructions is more robust and results in image quality comparable to the fully-sampled scan (Fig. 4).

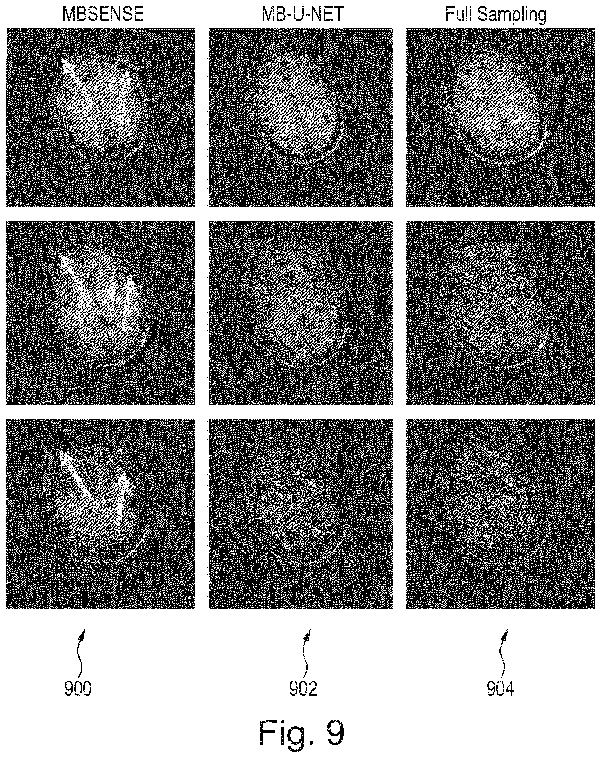

Fig. 9 illustrates the effectiveness of using a neural network to perform a reconstruction for an MB SENSE reconstruction. The images in column 900 have been reconstructed using a conventional algorithm for performing the MB SENSE reconstruction. The image shows a number of static motion artifacts that were called by a fixed change of the head position between the reference scan used to get the coil sensitivity map and the scan for the images. There are a number of ghosting artifacts which are pointed out by the arrows. In the middle column 902 are images that are reconstructed using the neural network. It can be seen that there are no ghosting images. In the third column 904 are images that were reconstructed using full sampling of k-space. It can be seen that the images in column 902 compare very favorably to the fully sampled images 904. The reconstruction of the neural network was able to avoid the artifacts that are visible in the images in column 900.

Example 2:

Data pre- and post-processing

For some neural network architectures, such as the proposed U-NET architecture it may be beneficial to use some special data pre- and post-processing in both k-space and image domain, which is outlined in more detail in the following. The employed U-NET disentangles the aliased (i.e. superimposed) MB images via different output channels, but does not correct for the CAIPIRINHA shift, which has to be done retrospectively as post-processing step by cyclic shifts of the output images by a certain fraction of the FOV (field-of-view) in PE direction (phase encoding, for the examples shown here: left-right). For instance, in the example shown above, two of the three images have to be shifted by one third of the FOV to the left or right, respectively, to have the anatomy in the image center again. If the pixel size of the image is not a multiple of three in PE direction, some kind of interpolation it may be beneficial to perform the resulting sub-pixel shift. This can be avoided by appropriate pre-processing of the acquired k-space data by zero-padding in the k-space domain before images are reconstructed by Fourier transformation. For the example shown above, one would add empty lines to aim for a multiple of three k-space lines in total (e.g. 258 instead of 256). Then, the CAIPIRINHA shift is a pure integer pixel shift of the final image, which is easy to perform.

Another pre- and post-processing step relates to the stitching artifact removal. The stitching artifact is due to the fact that the employed U-NET implementation does not perform a cyclic convolution of the data, although the input images are cyclic in PE direction (see e.g. Fig. 7, means that the image could be repeated after the last line on the right with the first line on the left). Hence, the first and last lines of the output images are corrupted and cause a dark stitching artifact after shifting the image to the center. This could be ideally addressed by performing cyclic convolutions in the neural network. However, this is not supported by the chosen Neural Network platform (Tensorflow). Therefore, additional pre-and post-processing steps were performed as workaround. The input images were cyclically continued by a few lines on the left and the right before feeding it into the network. This was done by copying small stripes of data from left to right and vice versa (Fig. 8). The artifact is then in a redundant area of the image and can be removed by cropping the output images to the original size before performing the shift to the center again.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

100     receiving initial training data
102     generating additional training data by performing data augmentation on the initial training dataw where the data augmentation comprises adding a distinct phase offset to each of the set of initial training complex channel images during generation of the sets of additional training complex channel images
104     inputting the sets of additional training complex channel images into the neural network and receiving in response a predetermined number of output training images
106     calculating a training vector by inputting the predetermined number of output training images and the predetermined number of ground truth images into a loss function
108     training the neural network by controlling a backpropagation algorithm with the training vector
200     medical system
202     computer
204     processor
206     hardware interface
208     user interface
210     memory

EP 3 839 547 A1

| | |
|---|---|
| 212 | machine executable instructions |
| 214 | neural network |
| 216 | multiple measured complex channel images |
| 218 | predetermined numer of reconstructed images |
| 300 | receive the multiple measured complex channel images |
| 302 | receive the predetermined number of reconstructed images by inputting multiple measured complex channel images into the neural network |
| 400 | medical system |
| 402 | magnetic resonance imaging system |
| 400 | medical instrumnet |
| 402 | magnetic resonance imaging system |
| 404 | magnet |
| 406 | bore of magnet |
| 408 | imaging zone |
| 409 | region of interest |
| 410 | magnetic field gradient coils |
| 412 | magnetic field gradient coil power supply |
| 414 | radio-frequency coil |
| 415 | antenna element |
| 416 | transceiver |
| 418 | subject |
| 420 | subject support |
| 430 | pulse sequence commands |
| 432 | antenna element dependent k-space data |
| 434 | optional coil sensitivity map k-space data |
| 436 | coil sensitivity map |
| 438 | SENSE reconstruction algorithm |
| 440 | algroithmically reconstructed images |
| 442 | image artifact detection module |
| 444 | quality indicator |
| 446 | subject image |
| 500 | acquire the antenna element dependent k-space data by controlling the magnetic resonance imaging system with the pulse sequence commands |
| 502 | reconstruct the multiple measured complex channel images from the antenna element dependent k-space data |
| 504 | acquire the coil sensitive map k-space data by controlling the magnetic resonance imaging system with the pulse sequence commands |
| 506 | reconstruct a coil sensitivity map from the coil sensitivity map k-space data |
| 508 | reconstruct a predetermined number of algorithmically reconstructed images from the antenna element dependent k-space data and the coil sensitivity map |
| 510 | receive a quality indicator descriptive of the predetermined number of algorithmically reconstructed images, wherein the quality indicator indicates a successful reconstruction or a failed reconstruction |
| 512 | store the predetermined number of reconstructed images as the subject images in the memory if the quality indicator indicates a failed reconstruction |
| 514 | store the predetermined number of algorithmically reconstructed images as subject images in the memory if the quality indicator indicates a successful reconstruction |
| 600 | fully sampled complex multi-coil data |
| 602 | channel |
| 604 | artifical Caipirinha shift |
| 606 | additional ground truth images |
| 608 | additional training complex channel images |
| 700 | synthesized data |
| 702 | measusred MB data |
| 800 | images with stitching artifacts |
| 802 | example of cyclic padding of input images |
| 803 | paddig region |
| 804 | result of using cyclic padding |
| 900 | images reconstructed using MB SENSE algorithm |
| 902 | reconstuction using neural network |

904    fully sampled images

**Claims**

1.  A method of training a neural network (214) to perform a SENSE magnetic resonance imaging reconstruction, wherein the neural network is configured to output a predetermined number of reconstructed images (218) in response to inputting multiple measured complex channel images (216) acquired according to a SENSE magnetic resonance imaging protocol, wherein the method comprises:

    - receiving (100) initial training data, wherein the initial training data comprises sets of initial training complex channel images each paired with a predetermined number of initial ground truth images;
    - generating (102) additional training data by performing data augmentation on the initial training data, wherein the additional training data comprises sets of additional training complex channel images each paired with a predetermined number of additional ground truth images, wherein the data augmentation comprises adding a distinct phase offset to each of the set of initial training complex channel images during generation of the sets of additional training complex channel images;
    - inputting (104) the sets of additional training complex channel images into the neural network and receiving in response a predetermined number of output training images;
    - calculating (106) a training vector by inputting the predetermined number of output training images and the predetermined number of ground truth images into a loss function; and
    - training (108) the neural network by controlling a backpropagation algorithm with the training vector.

2.  The method of claim 1, wherein the method further comprises removing a stitching artifact (800) from the predetermined number of output training images before calculating the training vector.

3.  The method of claim 1, wherein the neural network comprises convolutional layers, and wherein the convolutional layers are cyclical convolutional layers.

4.  The method of claim 1, wherein the method further comprises cyclically padding boundaries (803) of the additional training complex channel images before inputting them into the neural network.

5.  The method of any one of the preceding claims, wherein the SENSE magnetic resonance imaging protocol is a multi-band SENSE magnetic resonance imaging protocol configured for acquiring a predetermined number of slices simultaneously, wherein each of the predetermined number of output training images corresponds to one of the predetermined number of slices, and each of the predetermined number of output training images is offset by a layer dependent translational shift, wherein the method further comprises shifting each of the each of the predetermined number of ground truth images by the layer dependent translational shift before calculating the training vector.

6.  The method of any one of the preceding claims, wherein the distinct phase offset to each of the set of initial training complex channel images is selected from any one of the following: a pseudorandom phase angle distribution, a random phase angle distribution, a chosen list of phase angles, and combinations thereof.

7.  A medical system (200, 300) comprising:

    - a memory (210) storing machine executable instructions and a neural network (214), wherein the neural network is configured for performing a SENSE magnetic resonance imaging reconstruction by outputting a predetermined number of reconstructed images (218) in response to inputting multiple measured complex channel images (214) acquired according to a SENSE magnetic resonance imaging protocol;
    - a processor (204) configured for controlling the medical system, wherein execution of the machine executable instructions causes the processor to:

        - receive (300) the multiple measured complex channel images; and
        - receive (302) the predetermined number of reconstructed images by inputting multiple measured complex channel images into the neural network.

8.  The medical system of claim 7, wherein the neural network is trained according to any one of claims 1 through 6.

9. The medical system of claim 7 or 8, wherein the neural network is trained according to claim 2, wherein execution of the machine executable instructions further causes the processor to removing a stitching artifact from each of the each of the predetermined number of reconstructed images.

10. The medical system of claim 7 or 8, wherein the neural network is trained according to claim 4, wherein execution of the machine executable instructions further causes the processor to cyclically padding boundaries of the multiple measured complex channel images before inputting them into the neural network.

11. The medical system of any one of claims 7 through 10, wherein the neural network is trained according to claim 5, wherein the SENSE magnetic resonance imaging protocol is a multi-band SENSE magnetic resonance imaging protocol configured for acquiring a predetermined number of slices simultaneously, wherein each of the predetermined number of reconstructed images corresponds to one of the predetermined number of slices, and each of the predetermined number of output training images is offset by a layer dependent translational shift, wherein execution of the machine executable instructions further causes the processor to shift each of the each of the predetermined number reconstructed images by the layer dependent translational shift.

12. The medical system of any one of claims 7 through 10, wherein the predetermined number is one.

13. The medical system of any one of claims 7 through 12, wherein the medical system further comprises a magnetic resonance imaging system (402), wherein the magnetic resonance imaging system comprises a multi-channel RF system (416) configured for acquiring antenna element dependent k-space data (432) from an imaging zone (408) of the magnetic resonance imaging system, wherein the memory further stores pulse sequence commands (430) configured for acquiring the antenna element dependent k-space data according to the SENSE magnetic resonance imaging protocol, wherein execution of the machine executable instructions further cause the processor to:

- acquire (500) the antenna element dependent k-space data by controlling the magnetic resonance imaging system with the pulse sequence commands; and
- reconstruct (502) the multiple measured complex channel images from the antenna element dependent k-space data;

14. The medical system of claim 13, wherein the pulse sequence commands are further configured to control the magnetic resonance imaging system to acquire coil sensitivity map k-space data (434) according to the SENSE magnetic resonance imaging protocol, wherein execution of the machine executable instructions further cause the processor to:

- acquire (504) the coil sensitivity map k-space data by controlling the magnetic resonance imaging system with the pulse sequence commands;
- reconstruct (506) a coil sensitivity map (436) from the coil sensitivity map k-space data;
- reconstruct (508) a predetermined number of algorithmically reconstructed images from the antenna element dependent k-space data and the coil sensitivity map;
- receive (510) a quality indicator descriptive of the predetermined number of algorithmically reconstructed images, wherein the quality indicator indicates a successful reconstruction or a failed reconstruction;
- store (514) the predetermined number of algorithmically reconstructed images as subject images in the memory if the quality indicator indicates a successful reconstruction; and
- proceed with inputting multiple measured complex channel images into the neural network if the quality indicator indicates a failed reconstruction; and
- store (512) the predetermined number of reconstructed images as the subject images in the memory if the quality indicator indicates a failed reconstruction.

15. computer program product comprising a neural network (214) and machine executable instructions (212) for execution by a processor (204) controlling a medical system (200, 400), wherein the neural network is configured for performing a SENSE magnetic resonance imaging reconstruction by outputting a predetermined number of reconstructed images (218) in response to inputting multiple measured complex channel images (216) acquired according to a SENSE magnetic resonance imaging protocol, wherein execution of the machine executable instructions causes the processor to:

- receive (300) the multiple measured complex channel images; and
- receive (302) the at least one reconstructed image by inputting multiple measured complex channel images into the neural network.

receive initial training data — 100

generate additional training data via data augmentation with phase offsets — 102

input additional training complex channel images into NN to generate output images — 104

calculate training vector — 106

train NN by controlling backprop algorithm with training vector — 108

Fig. 1

Fig. 2

receive the multiple measured complex channel images — 300

receive the predetermined number of reconstructed images from the neural network — 302

# Fig. 3

Fig. 4

Fig. 5

Fig. 6

Synthesized data

measured MB data

700

702

Fig. 7

EP 3 839 547 A1

Fig. 8

Fig. 9

Europäisches
Patentamt

European
Patent Office

Office européen
des brevets

# EUROPEAN SEARCH REPORT

**Application Number**

EP 19 21 6400

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KINAM KWON ET AL: "A parallel MR imaging method using multilayer perceptron", MEDICAL PHYSICS., vol. 44, no. 12, 25 September 2017 (2017-09-25), pages 6209-6224, XP055701928, US ISSN: 0094-2405, DOI: 10.1002/mp.12600 | 1,2,4-15 | INV. G01R33/561 G01R33/483 G01R33/56 G06N3/08 |
| Y | * abstract, sections 1, 2.D, 2.E, 2.F (last paragraph), 3.D and 4; figure 1 * | 3 | ADD. G01R33/565 |
| Y | JOSEPH Y CHENG ET AL: "Compressed Sensing: From Research to Clinical Practice with Data-Driven Learning", ARXIV.ORG, CORNELL UNIVERSITY LIBRARY, 201 OLIN LIBRARY CORNELL UNIVERSITY ITHACA, NY 14853, 19 March 2019 (2019-03-19), XP081155157, * section 2.3 * | 3 | |

**TECHNICAL FIELDS SEARCHED (IPC)**

G01R
G06N

The present search report has been drawn up for all claims

| Place of search | Date of completion of the search | Examiner |
|---|---|---|
| Munich | 17 June 2020 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BILGIC.** Highly accelerated multishot echo planar imaging through synergistic machine learning and joint reconstruction. *Magnetic Resonance in Medicine,* 2019, vol. 82, 1343-1358